# DEMANDE DE BREVET EUROPEEN

(11) **EP 1 054 445 A1**
(43) Date de publication de la demande: **22.11.2000**
(21) Numéro de dépôt: 00401329.8
(22) Date de dépôt: 16.05.2000
(51) Int. Cl.: H01L 23/14

(54) **Boîtier électronique sur plaque et procédé de fabrication d'un tel boîtier**

(30) Priorité: 19.05.1999 FR 9906343
(71) Demandeur: SAGEM SA, 75016 Paris (FR)
(72) Inventeur: Boutin, Xavier, 78150 Le Chesnay (FR); Dreyfus, Alain, 95520 Osny (FR); Hoche, Jean, 76800 Saint Etienne du Rouvray (FR); Prolonge, Alain, 95800 Courdimanche (FR)
(74) Mandataire: Fort, Jacques

(57) **Abrégé**

Le boîtier électronique comporte une plaque (10) en aluminium pur ou allié constituant radiateur, dont au moins une face comporte des cavités (38) et/ou des tranchées (36) et est recouverte d'une couche oxydée portant un réseau de pistes conductrices sérigraphiées dont certaines au moins recouvrent les tranchées si des tranchées sont prévues. Des microcomposants électroniques ont des sorties reliées à certaines des pistes par brasure. Certains au moins sont montés dans les cavités si des cavités sont prévues.

## Description

La présente invention a pour objet un boîtier électronique comprenant une plaque en aluminium pur ou allié constituant un radiateur de chaleur, présentant en surface une couche oxydée isolante et portant un réseau de pistes de liaison équipotentielle destiné à recevoir des microcomposants électroniques.

Elle trouve une application particulièrement importante, bien que non exclusive, dans le domaine de l'industrie automobile où on recherche des constitutions aussi simples que possible et où d'autre part il est souvent nécessaire de dissiper des puissances thermiques importantes dans une ambiance à température relativement élevée.

On connaît déjà des procédés d'oxydation anodique de l'aluminium permettant d'obtenir une couche superficielle d'oxyde sur laquelle on peut ensuite former par sérigraphie des pistes conductrices. Un procédé avantageux pour atteindre ce résultat est décrit dans la demande de brevet FR 97 06107 (EP-A-0 880 310).

La présente invention vise notamment à fournir un boîtier électronique du genre ci-dessus défini particulièrement adapté au cas où certains au moins des pistes et microcomposants sont parcourus par des courants élevés.

L'invention propose en conséquence un boîtier électronique suivant la revendication 1.

Lorsque l'on forme alors les pistes de liaison équipotentielle par une technique courante de sérigraphie, les pistes qui se trouveront au-dessus des tranchées présenteront une épaisseur et donc, à largeur donnée, une section supérieure car les encres de sérigraphie sont amenées à un niveau sensiblement constant avant cuisson. Il suffit de pratiquer de telles tranchées au droit des pistes qui doivent véhiculer des courants élevés pour leur donner une section plus importante. On peut ainsi réduire la largeur des pistes véhiculant des courants élevés et l'encombrement de ces pistes, donc augmenter la densité d'implantation.

Le boîtier électronique peut comporter des circuits de puissance aussi bien que des circuits de commande. Grâce au contact direct entre les composants et la plaque en aluminium constituant substrat, le transfert de chaleur s'effectue par un trajet présentant une faible résistance thermique. La couche oxydée peut être en effet très mince, à condition d'utiliser des techniques d'anodisation évitant la présence de fissures ou piqûres (pinholes). Pratiquement, l'épaisseur de la couche oxydée sera généralement comprise entre 10 et 200 µm.

En plaçant des composants dans des cavités on réduit leur saillie et donc l'encombrement du boîtier.

L'invention vise également à fournir un procédé de fabrication d'un boîtier électronique suivant lequel :
- on réalise une plaque en aluminium pur ou allié, dans laquelle on ménage des tranchées et/ou des cavités,
- on recouvre la plaque et les trous par une couche oxydée et on forme un réseau de pistes de liaison équipotentielle sur la plaque, certaines au moins des pistes étant au dessus des tranchées si des tranchées sont prévues,
- on monte des microcomposants électroniques sur la dite face et on fixe leurs sorties sur des pistes par brasure, certains au moins des microcomposants étant dans les cavités si des cavités sont prévues dans la plaque et on les relie aux pistes par brasure.

Le procédé est particulièrement avantageux dans le cas de boîtiers dont certaines pistes et certains microcomposants seulement sont traversés par des courants élevés.

La section de passage de courant dans les pistes pourra en effet être alors adaptée à largeur constante.

Si on dispose les microcomposants de puissance dans des alvéoles avec les pattes de contact à l'arrière, on améliore les transferts thermiques entre ces microcomposants et la plaque du fait de leur contact par toute leur surface dépourvue de plages de liaison électrique avec la plaque.

On peut ainsi adapter aisément la section des pistes en fonction de la puissance qu'elle véhicule et/ou disposer les circuits de puissance de façon telle que leur dissipation thermique soit évacuée dans de meilleures conditions et que leur encombrement soit réduit.

Dans la pratique, on utilisera souvent une plaque d'aluminium ayant quelques millimètres d'épaisseur seulement. Cette plaque peut comporter des saillies sur la face opposée à celle qui porte les microcomposants (ou du moins la majeure partie des microcomposants). Les tranchées et/ou logements peuvent avoir quelques dixièmes de millimètre de profondeur.

Suivant l'épaisseur de la plaque en aluminium, elle pourra être fabriquée par des procédés différents. Souvent elle pourra être fabriquée par moulage. Si les tranchées et cavités sont peu profondes, elles peuvent être réalisées par simple emboutissage. Dans le cas d'une plaque épaisse et de cavités ou alvéoles profonds, il pourra être nécessaire d'usiner les alvéoles.

La présente invention vise également à fournir un boîtier électronique du genre ci-dessus défini comportant un connecteur de sortie directement fixé à la plaque, constituant avec elle un ensemble monobloc et réalisable par un procédé simple de fabrication.

Pour cela, l'invention utilise l'oxydation superficielle de l'aluminium pour réaliser une couche isolante sur des trous de traversée de la plaque destinés à recevoir des broches de connexion électrique.

L'invention propose en conséquence un boîtier électronique comportant :
- une plaque en aluminium pur ou allié constituant radiateur, percée d'un réseau de trous de passage, au moins une face et les trous étant recouverts d'une couche oxydée portant un réseau de pistes de liaison équipotentielle sur la face,
- des microcomposants électroniques ayant des sorties fixées sur certaines des pistes par brasure, et
- des broches de connexion électrique traversant la plaque, reliées par brasure à des pistes du réseau et faisant saillie sur la face opposée de la plaque dans un connecteur fixé à la plaque et destiné à recevoir un connecteur complémentaire.

Le connecteur fixé à la plaque peut être rendu étanche par un enrobage interne ou "potting" enveloppant les broches. Le connecteur, étant placé du côté opposé à la face qui reçoit le microcomposant électronique libère totalement cette face.

Lorsque le boîtier comporte à la fois des circuits de puissance et des circuits de signal, les broches du connecteur seront souvent de types différents. Il est possible de les incorporer dans un même connecteur ou dans des connecteurs différents placés l'un et l'autre à l'opposé de la face qui porte des microcomposants.

L'invention vise également à fournir un procédé de fabrication d'un boîtier électronique suivant lequel :
- on réalise une plaque en aluminium pur ou allié, dans laquelle on ménage un réseau de trous de passage,
- on recouvre la plaque et les trous par une couche oxydée et on forme un réseau de pistes de liaison équipotentielle sur la plaque,
- on monte des microcomposants électroniques sur la dite face et on fixe leurs sorties sur des pistes par brasure, et
- on monte des broches de connexion électrique à travers la plaque dans les trous, les broches faisant saillie sur la face opposée de la plaque , et on les relie par brasure à des pistes du réseau au cours de la même étape que la fixation des microcomposants.

Du fait que les broches sont brasées aux pistes au cours de la même étape de brasage que celle qui sert à fixer les microcomposants électroniques, le procédé de fabrication est simplifié. Par ailleurs, la couche d'oxyde revêtant la paroi des trous assure un isolement entre les broches. Il n'est en conséquence plus nécessaire de garantir cet isolement par une injection de résine entre la paroi des trous et les broches.

Les caractéristiques ci-dessus ainsi que d'autres apparaîtront mieux à la lecture de la description qui suit de modes particuliers de réalisation, donnés à titre d'exemple non limitatif. La description se réfère aux dessins qui l'accompagnent, dans lesquels :
- les figures 1A à 1C,où l'échelle n'est pas respectée pour plus de clarté, sont des schémas montrant des étapes successives de fabrication d'un boîtier suivant un mode particulier de réalisation de l'invention ;
- la figure 2 est un schéma montrant un détail d'un montage possible ;
- la figure 3 montre schématiquement un boîtier complet ;
- les figures 4A à 4E, où l'échelle n'est pas respectée pour plus de clarté, sont des schémas montrant des étapes successives de fabrication d'un boîtier suivant un mode particulier de réalisation de l'invention ;
- la figure 5 est un schéma à grande échelle montrant le montage d'un connecteur.

Il sera essentiellement question par la suite de circuits simple face dont la plaque est oxydée sur les deux faces. On peut toutefois constituer des circuits double face ou n'oxyder que la face de la plaque qui porte des microcomposants en utilisant des techniques courantes de masquage.

Le produit de départ est une plaque mince d'aluminium pur ou à faible teneur en magnésium. Pour augmenter la capacité de dissipation thermique la face de la plaque opposée à celle qui reçoit les microcomposants a avantageusement des saillies augmentant sa surface. Pour des applications automobiles on donnera en général à la plaque une épaisseur comprise entre 2 et 30 mm.

Dans la plaque 10 sont ménagées, aux emplacements destinés à des pistes de section droite importante, qui doivent véhiculer des courants élevés, des tranchées 36 de quelques dixièmes de millimètre de profondeur. Des logements ou cavités 38 sont également ménagés pour recevoir certains des microcomposants (ou tous).

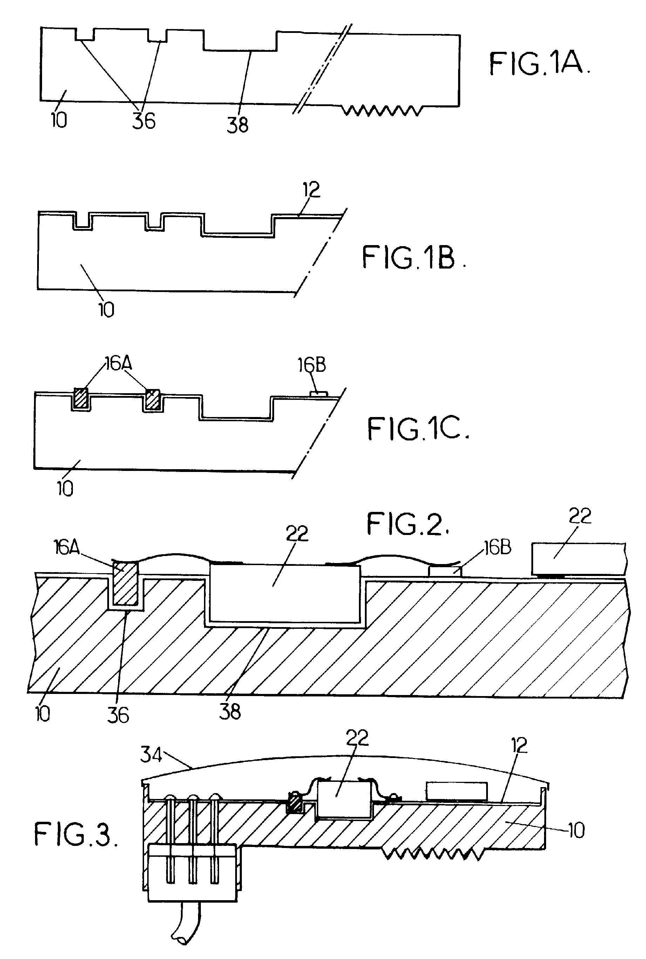

La plaque 10 ainsi obtenue, du genre montré en fig. 1A, est soumise à une oxydation anodique donnant naissance à une couche d'oxyde superficielle 12. Cette couche aura avantageusement entre 90 et 140 micromètres d'épaisseur. Elle doit être exempte de fissures de façon à garantir l'isolement électrique. Pour cela on peut notamment, mais non exclusivement, utiliser le procédé décrit dans la demande FR 97 06107 ou le document EP-A-0880310.

La plaque oxydée sera généralement ensuite nettoyée pour enlever les contaminants et les pores de la pellicule isolante sont bouchés, par exemple par de l'oxyde de silicium ou des résines type époxy. Divers procédés sol-gel sont également utilisables.

La plaque oxydée reçoit ensuite un réseau de pistes équipotentielles. On peut former directement ces pistes par sérigraphie. On peut utiliser une encre de sérigraphie à cuisson à base température pour réduire les contraintes thermiques. Cependant il est apparu possible, moyennant une formation d'oxyde donnant à ce dernier une légère souplesse, d'adopter des encres avec cuisson vers 500°C.

Dans certains cas les pistes déposées sur la pellicule d'oxyde sont directement reliées aux microcomposants. Cependant on peut aussi utiliser un procédé donnant naissance à deux couches de métallisation. Dans ce cas une couche diélectrique est déposée sur les pistes conductrices et des vias sont ménagés. Sur la couche diélectrique est réalisée une nouvelle couche comportant des pistes et plages de raccordement.

Dans le cas illustré sur la figure 1C, une seule couche de métallisation est prévue. Lors de la mise en place de l'encre de métallisation par sérigraphie, l'encre remplit les tranchées 36. Lorsque l'encre en excès est raclée, il subsiste une épaisseur d'encre au dessus du fond des tranchées plus importante qu'au dessus de la partie plate de la plaque. En conséquence la section de passage de courant offerte par les pistes 16A au dessus de tranchées est supérieure à celle des autres pistes 16B.

La plaque ainsi traitée est placée sur un support. Les microcomposants 22 sont mis en place et fixés par brasage, généralement à l'aide de soudure étain-plomb.

Les composants 22 placés dans des alvéoles 38 peuvent être montés à l'envers pour que leur face dépourvue de contacts repose contre le fond de l'alvéole. D'une part leur saillie est réduite et d'autre part les liaisons par fils souples et brasage avec des pistes 16A et/ou 16B sont raccourcies.

L'ensemble ainsi constitué peut recevoir un capot de protection 34 enveloppant les microcomposants, qui sont ainsi isolés de l'environnement.

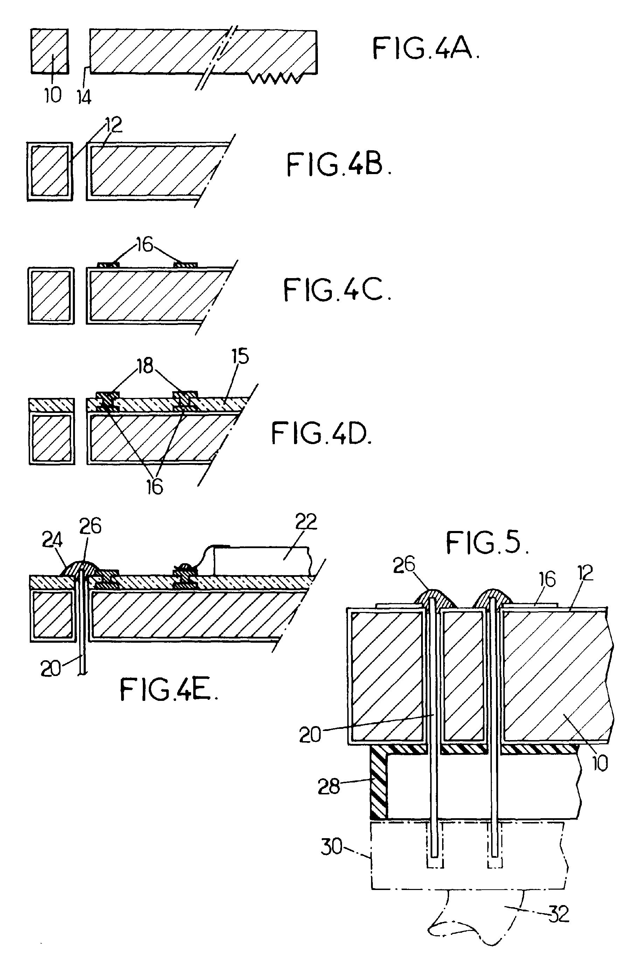

Dans le mode de réalisation des figures 4A-4E, le produit de départ est encore une plaque mince d'aluminium pur ou à faible teneur en magnésium. Elle est tout d'abord percée d'un réseau de trous destinés à recevoir les broches d'un connecteur qui sera placé sur la face de la plaque opposée à celle qui reçoit des microcircuits.

La plaque 10 ainsi obtenue, du genre montré en fig. 4A où un seul trou est représenté, est soumise à une oxydation anodique donnant naissance à la couche d'oxyde superficielle 12. Cette couche doit être exempte de fissures de façon à garantir l'isolement électrique de broches qui seront montées dans les trous 14.

La plaque oxydée, puis nettoyée, reçoit encore un réseau de pistes équipotentielles. On peut notamment former directement ces pistes 16 par sérigraphie (Fig. 1C).

On décrira ici un procédé donnant naissance à deux couches de métallisation. Dans ce cas une couche diélectrique 15 est déposée sur les pistes conductrices et des vias sont ménagés, y compris au droit des trous. Sur la couche 15 est réalisée une nouvelle couche comportant des pistes et plages de raccordement 18 (Fig. 4D).

La plaque ainsi traitée est placée sur un support. Les broches 20 sont mises en place ainsi que les microcomposants 22. Les unes et les autres sont alors fixés par brasage, généralement à l'aide de soudure étain-plomb. Le connecteur 24 dans lequel les broches doivent être fixées de façon permanente peut être mis en place dès ce stade pour maintenir les broches à leur emplacement correct. Les points de brasure recouvrent les têtes des broches (Fig. 4E) et s'étendent sur les plages de connexion appropriées.

Dans le cas illustré sur la figure 5, une seule couche de métallisation est prévue et les broches sont directement brasées sur les pistes 16 appropriées. La figure 5 montre également le connecteur 28 auquel les broches sont fixées de façon permanente. Les liaisons peuvent être rendues étanches en noyant l'intérieur du connecteur par une résine polymérisable qui retient également les broches. Le connecteur 28 est destiné à recevoir un connecteur complémentaire amovible 30 relié à un câble souple 32. Le connecteur 28 contient des contacts femelles de liaison avec les broches.

L'ensemble peut encore recevoir un capot de protection 34. L'enrobage du connecteur, qui peut également envahir les trous 14, sépare l'intérieur du capot de l'atmosphère.

## Revendications

1. Boîtier électronique comportant :
- une plaque (10) en aluminium pur ou allié constituant radiateur, dont au moins une face comporte des tranchées (36) et est recouverte totalement d'une couche oxydée portant un réseau de pistes conductrices sérigraphiées dont certaines au moins recouvrent des tranchées, et
- des microcomposants électroniques ayant des sorties reliées à certaines des pistes par brasure.

2. Boîtier suivant la revendication 1, caractérisé en ce que ladite face comporte des cavités (38) et certains au moins des microcomposants sont montés dans les cavités.

3. Boîtier suivant la revendication 1, caractérisé en ce que certains au moins des composants (22) placés dans les cavités sont montés à l'envers pour que leur face dépourvue de contacts électriques repose contre le fond de l'alvéole.

4. Boîtier suivant la revendication 1, 2 ou 3, caractérisé en ce qu'il comporte un capot d'étanchéité enveloppant les microcomposants et dont les bords sont-fixés aux bords de la plaque.

5. Boîtier suivant l'une quelconque des revendications 1 à 4, caractérisé en ce que la face de la plaque opposée à celle qui porte les microcomposants présente des saillies d'augmentation de la dissipation thermique.

6. Boîtier électronique suivant l'une quelconque des revendications 1 à 5, caractérisé en ce que la plaque est percée d'un réseau de trous de passage, au moins une face et les trous étant recouverts de la couche oxydée, et en ce que des broches de connexion électrique traversent la plaque, sont reliées par brasure à des pistes du réseau et font saillie sur la face opposée de la plaque dans un connecteur fixé à la plaque et destiné à recevoir un connecteur complémentaire.

7. Boîtier suivant la revendication 6, caractérisé en ce que le connecteur fixé à la plaque présente un enrobage interne d'étanchéité.

8. Boîtier suivant la revendication 6 ou 7, caractérisé en ce qu'il comporte un capot d'étanchéité enveloppant les microcomposants et les parties brasées des broches, contenant un enrobage et dont les bords sont fixés aux bords de la plaque.

9. Procédé de fabrication d'un boîtier suivant l'une quelconque des revendications 1 à 5, comportant les étapes suivantes :
- on réalise une plaque en aluminium pur ou allié, dans laquelle on ménage des tranchées et éventuellement des cavités,
- on recouvre la plaque, les tranchées et les cavités éventuelles par une couche oxydée et on forme un réseau de pistes de liaison équipotentielle sur la plaque, certaines au moins des pistes étant au-dessus des tranchées,
- on monte des microcomposants électroniques sur la dite face et on fixe leurs sorties sur des pistes par brasure, certains au moins des microcomposants étant dans les cavités si des cavités sont prévues dans la plaque, et on les relie aux pistes par brasure.

10. Procédé de fabrication d'un boîtier suivant l'une quelconque des revendications 6 à 8, comportant les étapes suivantes :
- on réalise une plaque (10) en aluminium pur ou allié, dans laquelle on ménage un réseau de trous de passage,
- on recouvre la plaque et les trous par une couche oxydée et on forme un réseau de pistes de liaison équipotentielle sur la plaque,
- on monte des microcomposants électroniques (22) sur la dite face et on fixe leurs sorties sur des pistes par brasure, et
- on monte des broches de connexion électrique (20) à travers la plaque dans les trous, les broches faisant saillie sur la face opposée de la plaque, et on les relie par brasure à des pistes du réseau au cours de la même étape que la fixation des microcomposants.
